# EUROPEAN PATENT APPLICATION

(11) **EP 2 088 629 A1**
(43) Date of publication of application: **12.08.2009**
(21) Application number: 07807788.0
(22) Date of filing: 21.09.2007
(51) Int. Cl.: H01L 29/786, H01L 21/28, H01L 21/283, H01L 21/336

(54) **SEMICONDUCTOR DEVICE AND SEMICONDUCTOR DEVICE MANUFACTURING METHOD**

(30) Priority: 22.09.2006 JP 2006257848; 20.11.2006 JP 2006313492
(71) Applicant: National University Corporation Tohoku Unversity, Sendai-shi, Miyagi 980-8577 (JP); Zeon Corporation, Tokyo 100-8246 (JP)
(72) Inventor: OHMI, Tadahiro, Sendai-shi Miyagi 980-8577 (JP); SUGITANI, Koichi, Tokyo 100-8246 (JP)
(74) Representative: Vossius & Partner
(86) International application number: PCT/JP2007/068458
(87) International publication number: WO 2008/035786

(57) **Abstract**

In a semiconductor device according to the present invention, an insulator layer on a substrate is provided with a trench. A gate electrode is formed in the trench so that an upper surface of the gate electrode is approximately flush with an upper surface of the insulator layer. On the gate electrode, a semiconductor layer is provided via a gate insulating film. At least one of a source electrode and a drain electrode is electrically connected to the semiconductor layer. Particularly, the gate insulating film includes an insulator coating film provided on the gate electrode, and an insulator CVD film formed on the insulator coating film.

## Description

### Technical Field

This invention relates to a semiconductor device, in particular a thin film transistor (TFT), and to a method of manufacturing the same. Background Art:

In general, in a display device, such as a liquid crystal display device, an organic EL device, and an inorganic EL device, conductive patterns, such as a wiring pattern and an electrode pattern are formed on a substrate having a flat main surface by sequential depositing and patterning. Thus, the display device is manufactured by sequentially depositing and patterning an electrode film, various films necessary for elements constituting the display device, and so on.

In recent years, there is a strong demand for an increase in size of the display device of the type. In order to form a large-sized display device, it is required to form a greater number of display elements on a substrate with high accuracy and to electrically connect these elements to a wiring pattern. In this case, in addition to the wiring pattern, an insulating film, TFT (thin film transistor) elements, light emitting elements, and so on are formed on the substrate in a multilayered state. As a result, level differences are generally formed on the substrate in a stepwise fashion and the wiring pattern is formed across the level differences.

Furthermore, when the display device is increased in size, the wiring pattern itself becomes long. Therefore, it is required to reduce a resistance of the wiring pattern. Techniques for eliminating the level differences of the wiring pattern and reducing the resistance are disclosed, for example, in Patent Document 1, Patent Document 2, and Patent Document 3. Patent Documents 1 through 3 disclose that, in order to form a wiring for a flat panel display, such as a liquid crystal display, a wiring is formed on a surface of a transparent substrate and a transparent insulating material having a height equivalent to that of the wiring is formed in contact with the wiring pattern. Further, Patent Document 3 discloses a method of further planarizing a wiring by hot press or CMP (Chemical Mechanical Polishing).

Patent Document 1: WO2004/110117
Patent Document 2: Jap2005-173050
Patent Document 3: JP-A-2005-210081
Patent Document 4: JP-A-2002-296780
Patent Document 5: JP-A-2001-188343

### Disclosure of the Invention:

### Problem to be Solved by the Invention:

Patent Document 1 discloses that, by burying the wiring in a groove formed by a resin pattern to form a thick-film wiring, characteristics of a display device can be improved. Furthermore, as a method of forming the wiring, various techniques, such as ink-jet and screen printing, are disclosed.

However, it has been found that the disclosed method has a problem in adhesion to the substrate.

Meanwhile, it has also been found that, if the wiring is formed by a conductive ink, screen printing, or the like as described in Patent Document 1, the wiring has a rough surface to degrade flatness of an insulating layer and so on formed on the wiring. If the wiring formed by the conductive ink or the screen printing is used as a gate electrode, a phenomenon has been observed that, because of roughness of the wiring surface, a propagation rate of a carrier passing through a channel is lowered to become an obstacle to a high-speed operation. Further, it has also been found that, by the conductive ink, the screen printing, or the like, it becomes difficult to obtain a desired configuration as the wiring becomes finer. For example, when it is attempted to form a gate electrode having a width of 20 µm and a length of 50 µm by the above-mentioned techniques, it has been found that an electrode material does not spread over the entire surface and, therefore, formation of a desired pattern is practically impossible.

In order to solve the above-mentioned problems, Patent Document 2 proposes a manufacturing method including at least a step of modifying a surface of an insulating substrate so as to enhance adhesion to the substrate, a step of forming a resin film on the insulating substrate, a step of forming a concave portion for receiving an electrode or a wiring by patterning the resin film, a step of providing a catalyst to the concave portion, a step of heat-hardening the resin film, and a step of forming a conductive material in the concave portion by plating. A conductive metal layer as a gate electrode or the like, for example, a Cu layer is formed by electroless plating and thereon, as a Cu diffusion suppressing layer, a W layer is formed by selective CVD (Chemical Vapor Deposition) or a Ni layer is formed by electroless plating. Thus, the gate electrode is formed.

According to the above-mentioned method, adhesion of the gate electrode to the substrate is improved. Furthermore, even in a case of the gate electrode having a width of 20 µm and a length of 50 µm, a desirable pattern can be formed regardless of the size. However, it has been found that, even with this method, the gate electrode has a rough surface and a gate insulating layer formed on the gate electrode has a poor flatness. For example, a surface of the Cu layer formed by electroless plating has a flatness up to 17.74 nm in Ra and 193.92 nm in peak-to-valley value. A surface of the Ni layer formed thereon also has a flatness of 8.58 nm in Ra and 68.7 nm in peak-to-valley value. It has been found that, because of such a surface roughness, a surface of silicon nitride formed as a gate insulating film by CVD, that is, an interface with a channel region of a semiconductor layer is also rough and, as a result of surface scattering, mobility of a carrier is degraded. The gate electrode is required to have a surface roughness not greater than 1 nm in Ra and not greater than 20 nm in peak-to-valley value for the purpose of keeping a flatness at the interface between the gate insulating film and the channel region to prevent interface scattering of the carrier.

Patent Document 3 proposes, as a method for solving the problem of the roughness of the wiring surface, a process of performing hot-pressing, in which an insulating film and an embedded wiring are pressed by a pressing member, or performing CMP. However, with the increase in size of a mother glass substrate in recent years, especially for a fifth-generation glass substrate having a size of 1100 mm x 1300 mm or more, the above-mentioned methods of planarizing the wiring have become no longer realistic. In the hot pressing, slight deformation of the glass leads to a breakage. Further, uniform polishing of an entire surface of a large-sized glass substrate by CMP is extremely difficult and leads to an increase in cost.

Furthermore, a phenomenon has been observed that a gap is formed between a plated layer and a surrounding resin film. Presumably, this is because a resin is expanded by a high temperature in plating and contracted after the plating. In presence of such a gap, electric field concentration occurs in a gate insulating film to cause dielectric breakdown. This results in short-circuiting between a gate electrode and a channel region.

It is an object of the present invention to provide a thin film transistor (TFT) having a gate insulating film excellent in flatness, and a method of manufacturing the same.

It is another object of the present invention to provide a semiconductor device which solves the problems of surface roughness of a gate electrode and a gap between the gate electrode and a surrounding insulating layer, and a method of manufacturing the same.

It is still another object of the present invention to provide a display device including a thin film transistor excellent in interface flatness, and a method of manufacturing the same.

### Means to Solve the Problem:

Hereinbelow, aspects of the present invention will be described.

### (First Aspect)

According to a first aspect of the present invention, a semiconductor device is provided. The semiconductor device comprises a substrate, an insulator layer formed on the substrate and having a trench, a conductor layer formed in the trench so that an upper surface of the conductor layer is approximately flush with an upper surface of the insulator layer, an insulating film formed on the conductor layer, and a semiconductor layer formed on the insulating film above at least a part of the conductor layer, and is characterized by that the insulating film includes an insulator coating film.

### (Second Aspect)

In the semiconductor device according to the first aspect, the insulating film comprises only the insulator coating film.

### (Third Aspect)

In the semiconductor device according to the first aspect, the insulating film may further include an additional insulator film.

### (Fourth Aspect)

In the semiconductor device according to the third aspect, it is desirable that the additional insulator film is an insulator CVD film.

### (Fifth Aspect)

In the semiconductor device according to the third aspect, the additional insulator film is formed between the insulator coating film and the semiconductor layer.

### (Sixth Aspect)

In the semiconductor device according to the third aspect, the additional insulator film may be formed between the insulator coating film and the conductor layer.

### (Seventh Aspect)

In the semiconductor device according to the first aspect, a part of the conductor layer is a gate electrode, the insulating film on the gate electrode is a gate insulating film, and the semiconductor layer is formed on the gate insulting film.

### (Eighth Aspect)

In the semiconductor device according to the seventh aspect, at least one of a source electrode and a drain electrode is electrically connected to the semiconductor layer.

### (Ninth Aspect)

According to a ninth aspect of the present invention, a semiconductor device is provided. The semiconductor device comprises an insulator layer formed on a substrate and provided with a trench, a gate electrode formed in the trench so that an upper surface of the gate electrode is approximately flush with an upper surface of the insulator layer, and a semiconductor layer arranged on the gate electrode via a gate insulating film and electrically connected to at least one of a source electrode and a drain electrode. The semiconductor device is characterized by that the gate insulating film comprises an insulator coating film formed on the gate electrode and an insulator CVD film formed on the insulator coating film.

### (Tenth Aspect)

In the semiconductor device according to the seventh or ninth aspect, a surface of the insulator coating film has a flatness of not greater than 1 nm in Ra and not greater than 20 nm in peak-to-valley value.

### (Eleventh Aspect)

In the semiconductor device according to the seventh or ninth aspect, a surface of the gate electrode has a flatness of not smaller than 3 nm in Ra and not smaller than 30 nm in peak-to-valley value.

### (Twelfth Aspect)

In the semiconductor device according to the first or ninth aspect, the substrate is a substantially transparent insulator substrate, and the insulator layer is a substantially transparent resin layer.

### (Thirteenth Aspect)

In the semiconductor device according to the twelfth aspect, the resin layer is formed of a photosensitive resin composition containing an alkali-soluble alicyclic olefin-based resin and a radiation-sensitive component.

### (Fourteenth Aspect)

In the semiconductor device according to the twelfth aspect, the resin layer contains one or more kinds of resins selected from a group including an acryl-based resin, a silicone-based resin, a fluorine-based resin, a polyimide-based resin, a polyolefin-based resin, an alicyclic olefin-based resin, and an epoxy-based resin.

### (Fifteenth Aspect)

In the semiconductor device according to the seventh or ninth aspect, the gate electrode comprises at least a base adhesive layer, a conductive metal layer, and a conductive metal diffusion suppressing layer.

### (Sixteenth Aspect)

In the semiconductor device according to the first or ninth aspect, the insulator coating film fills a gap between the conductor layer and the insulator layer and extends over the surface of the insulator layer.

### (Seventeenth Aspect)

in the semiconductor device according to the seventh or ninth aspect, the insulator coating film is substantially transparent, fills a gap between the gate electrode and the insulator layer, and extends over the surface of the insulator layer.

### (Eighteenth Aspect)

In the semiconductor device according to the fourth or ninth aspect, the insulator CVD film is substantially transparent and extends over the insulator coating film extending over the surface of the insulator layer.

### (Nineteenth Aspect)

In the semiconductor device according to the first or ninth aspect, the insulator coating film is a film obtained by drying and baking a liquid coating film containing at least one of a metal organic compound and a metal inorganic compound and a solvent.

### (Twentieth Aspect)

In the semiconductor device according to the first or ninth aspect, the insulator layer is a substantially transparent resin layer, and the insulator coating film is a film obtained by drying and baking, at a temperature not higher than 300 °C, a liquid coating film containing at least one of a metal organic compound and a metal inorganic compound and a solvent.

### (Twenty-first Aspect)

In the semiconductor device according to the first or ninth aspect, it is desirable that the insulator coating film has a dielectric constant of not smaller than 2.6.

### (Twenty-second Aspect)

In the semiconductor device according to the fourth or ninth aspect, it is desirable that the insulator CVD film has a dielectric constant of not smaller than 4.

### (Twenty-third Aspect)

In the semiconductor device according to the seventh or ninth aspect, it is desirable that the gate insulating film has a thickness between 95 nm and 200 nm in EOT (equivalent silicon dioxide thickness).

### (Twenty-fourth Aspect)

In the semiconductor device according to the fourth or ninth aspect, it is desirable that the insulator CVD film has a thickness between 80 nm and 185 nm in EOT (equivalent silicon dioxide thickness).

### (Twenty-fifth Aspect)

In the semiconductor device according to the first or ninth aspect, it is desirable that the insulator coating film has a thickness between 15 nm and 120 nm in EOT (equivalent silicon dioxide thickness).

### (Twenty-sixth Aspect)

In the semiconductor device according to the fifteenth aspect, the conductive metal layer contains at least one of Cu and Ag, and the conductive metal diffusion suppressing layer contains a metal selected from Ni, W, Ta, Nb, and Ti.

### (Twenty-seventh Aspect)

According to the present invention, a display device manufactured by using the semiconductor device according to the first or ninth aspect is provided.

### (Twenty-eighth Aspect)

in the display device according to the twenty-seventh aspect, the display device is a liquid crystal display device or an organic EL display device.

### (Twenty-ninth Aspect)

According to a twenty-ninth aspect, a method of manufacturing a semiconductor device is provided. The method includes a step of providing an insulator layer having a trench on a substrate, a step of forming a conductor layer in the trench so that an upper surface of the conductor layer is approximately flush with an upper surface of the insulator layer, a step of forming an insulator coating film on the conductor layer, and a step of forming a semiconductor layer on at least a part of the insulator coating film.

### (Thirtieth Aspect)

In the method according to the twenty-ninth aspect, the method may include, before or after the step of forming the insulator coating film, a step of forming an additional insulator film.

### (Thirty-first Aspect)

In the method according to the twenty-ninth aspect, it is desirable that the additional insulator film is formed by CVD.

### (Thirty-second Aspect)

In the method according to the twenty-ninth aspect, a part of the conductor layer may be a gate electrode, the insulator coating film on the gate electrode may be at least a part of a gate insulating film, and the semiconductor layer may be formed on the gate insulating film.

### (Thirty-third Aspect)

In the method according to the twenty-ninth aspect, the method further includes a step of forming at least one of a source electrode and a drain electrode on the semiconductor layer.

### (Thirty-fourth Aspect)

In a method according to a thirty-fourth aspect, a method of manufacturing a semiconductor device is provided. The method includes a step of providing an insulator layer having a trench on a substrate, a step of forming a gate electrode in the trench so that an upper surface of the gate electrode is approximately flush with an upper surface of the insulator layer, a step of forming an insulator coating film on the gate electrode, a step of forming a dielectric film by CVD on the insulator coating film, a step of forming a semiconductor layer on the dielectric film, and a step of electrically connecting at least one of a source electrode and a drain electrode to the semiconductor layer.

### (Thirty-five Aspect)

In the method according to the thirty-second or thirty-fourth aspect, the step of forming the insulator coating film includes a step of applying, onto the gate electrode, a liquid material containing at least one of a metal organic compound and a metal inorganic compound and a solvent, a step of drying an applied film, and a step of baking a dried film.

### (Thirty-sixth Aspect)

In the method according to the thirty-second or thirty-fourth aspect, the step of forming the gate electrode includes a step of forming a conductive metal layer by plating, printing, ink-jet, or sputtering.

### (Thirty-seventh Aspect)

In the method according to the thirty-fifth aspect, the step of forming the insulator coating film includes a step of applying the liquid material so as to fill a gap between the gate electrode and the insulator layer and to extend over a surface of the insulator layer.

### (Thirty-eighth Aspect)

In the method according to the twenty-ninth or thirty-fourth aspect, the step of providing the insulator layer having the trench on the substrate includes a step of forming a resin film on the substrate and a step of forming the trench for receiving the gate electrode by patterning the resin film.

### (Thirty-ninth Aspect)

In the method according to the thirty-fifth aspect, the baking is carried out in an inactive gas atmosphere or in an air atmosphere.

### (Fortieth Aspect)

According to the present invention, a method of manufacturing a liquid crystal display device or an organic EL display device is provided. The method includes a step of forming a semiconductor device by using the method according to the twenty-ninth or thirty-fourth aspect.

### Effect of the Invention:

According to the present invention, the insulator coating film is formed on the gate electrode having a rough surface so that a flatness of its surface is not greater than 1 nm in Ra and not greater than 20 nm in peak-to-vailey value. As a result, the surface of the gate insulating film is planarized and an interface between the gate insulating film and a channel region becomes flat to prevent interface scattering of a carrier. Therefore, high carrier mobility can be achieved. Furthermore, the gap between the gate electrode and the surrounding insulating layer is filled to provide a flat surface across the gate electrode and a surface of the insulating layer. Therefore, breakage of the gate insulating film can be prevented.

### Brief Description of the Drawing:

Fig. 1 is a sectional view showing one example of a structure of a thin film transistor according to a first embodiment of the present invention.
Fig. 2 is an enlarged sectional view showing one example of a structure of a gate electrode portion of the thin film transistor illustrated in Fig. 1.
Fig. 3 is a sectional view for describing, step by step, one example of a method of manufacturing the thin film transistor illustrated in Fig. 1.
Fig. 4 is a sectional view for describing, step by step, the one example of the method of manufacturing the thin film transistor illustrated in Fig. 1.
Fig. 5 is a sectional view for describing, step by step, the one example of the method of manufacturing the thin film transistor illustrated in Fig. 1.
Fig. 6 is a sectional view for describing, step by step, the one example of the method of manufacturing the thin film transistor illustrated in Fig. 1.
Fig. 7 is a sectional view for describing, step by step, the one example of the method of manufacturing the thin film transistor illustrated in Fig. 1.
Fig. 8 is a view as a reproduction of a photograph showing an FIB section of an overcoat film in the thin film transistor according to the first embodiment of the present invention.
Fig. 9 is a sectional view showing one example of a structure of a thin film transistor according to a second embodiment of the present invention.
Fig. 10 is an enlarged sectional view showing one example of a structure of a gate electrode portion of the thin film transistor illustrated in Fig. 9.
Fig. 11 is a sectional view for describing, step by step, one example, of a method of manufacturing the thin film transistor illustrated in Fig. 9.
Fig. 12 is a sectional view for describing, step by step, the one example of the method of manufacturing the thin film transistor illustrated in Fig. 9.
Fig. 13 is a sectional view for describing, step by step, the one example of the method of manufacturing the thin film transistor illustrated in Fig. 9.
Fig. 14 is a sectional view for describing, step by step, the one example of the method of manufacturing the thin film transistor illustrated in Fig. 9.
Fig. 15 is a sectional view for describing, step by step, the one example of the method of manufacturing the thin film transistor illustrated in Fig. 9.
Fig. 16 is a sectional view showing one example of a structure of a thin film transistor according to a third embodiment of the present invention.
Fig. 17 is a view as a reproduction of a photograph showing an FIB section of an overcoat film in the thin film transistor according to the second embodiment of the present invention.

### Best Mode for Embodying the Invention:

A first embodiment of the present invention will be described using the drawing.

### [first Embodiment]

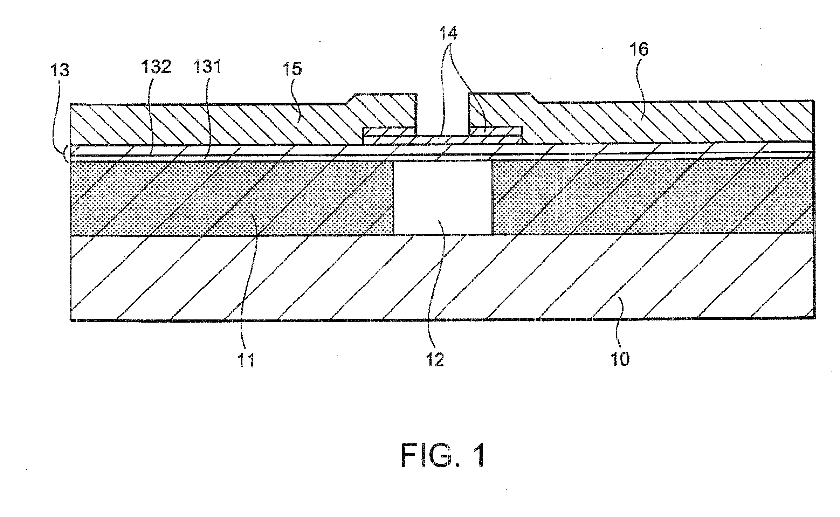

Fig. 1 is a sectional view showing one example of a structure of a thin film transistor (TFT) according to the present invention, which is applicable to a liquid crystal display device. Referring to Fig. 1, the thin film transistor has a transparent resin film. (insulator layer) 11 formed on a glass substrate (insulating substrate) 10 and formed of a transparent photosensitive resin, and a gate electrode (conductor layer) 12 formed in the transparent resin film 11 so as to reach the glass substrate 10 and formed to a height approximately same as that of the transparent resin film 11. The thin film transistor further has a gate insulating film 13 comprising an insulator coating film (overcoat film) 131 formed over the transparent resin film 11 and the gate electrode 12 and a CVD dielectric film (insulator CVD film) 132 formed thereon, a semiconductor layer 14 formed on the gate electrode 12 via the gate insulating film 13, and a source electrode 15 and a drain electrode 16 each of which is connected to the semiconductor layer 14.

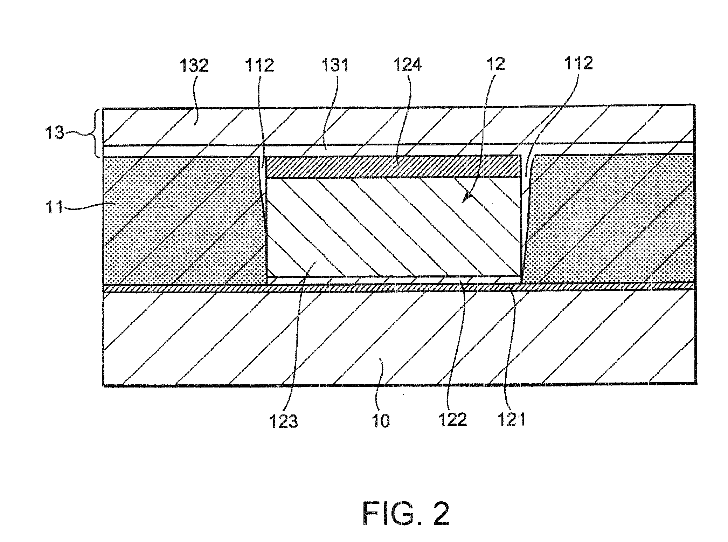

Fig. 2 is an enlarged sectional view showing a structure of a gate electrode portion of the thin film transistor according to the first embodiment. The gate electrode 12 illustrated in the figure is embedded in a trench formed in the flat transparent resin film 11 and comprises, from the side of the glass substrate 10 toward the side of the semiconductor layer (namely, in order from the bottom of the figure), a base adhesive layer 121, a catalyst layer 122, a conductive metal layer 123, and a conductive metal diffusion suppressing layer 124. As shown in the figure, the gate electrode 12 is embedded in the trench of the transparent resin film 11 so that an upper surface of the gate electrode and that of the transparent resin film 11 are approximately flush with each other. Therefore, flatness of an upper structure of the gate electrode 12 is ensured. However, there is a problem in flatness at a microscopic level. Specifically, a surface of the conductive metal layer 123 (Cu layer) formed by conventional electroless plating has a flatness up to 17.74 nm in Ra and 193.92 nm in peak-to-valley (P-V) value. A surface of the conductive metal diffusion suppressing layer 124 (electroless plated Ni layer) formed thereon also has a flatness of 8.58 nm in Ra and 68.7 nm in peak-to-valley value.

In the present invention, the insulator coating film 131 having a thickness of 40 nm is formed on the gate electrode 12 and the transparent resin film 11. The insulator coating film 131 fills a gap 112 between the gate electrode 12 and the transparent resin film 11 and provides a flat surface which does not reflect asperity of the surface of the gate electrode 12 and which has a flatness of 0.24 nm in Ra and 2.16 nm in peak-to-valley value. The above-mentioned values sufficiently satisfy those levels of not greater than 1 nm in Ra and not greater than 20 nm in peak-to-valley value which are required for the insulator coating film, even in case where the surface of the gate electrode has a flatness not smaller than 3 nm in Ra and not smaller than 30 nm in peak-to-valley value.

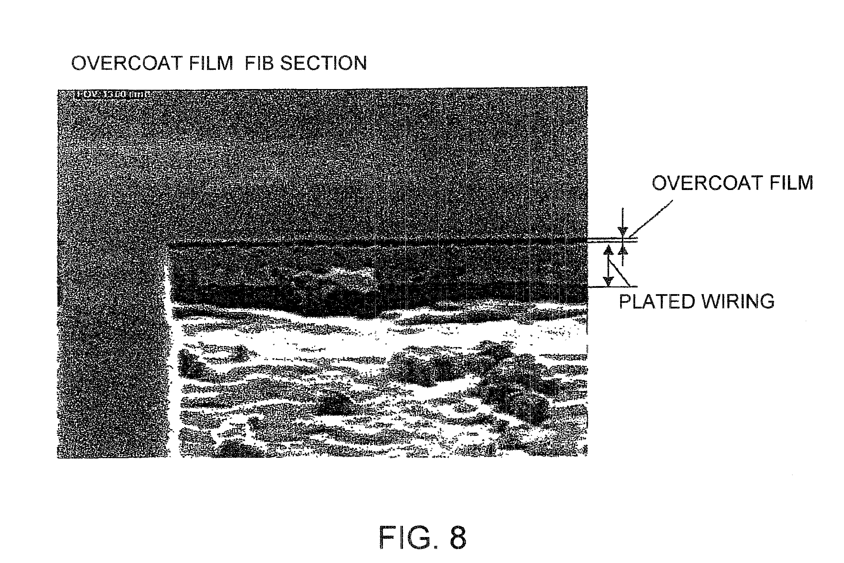

Fig. 8 is an electron micrograph showing a state, as observed in section by FIB machining, of a structure in which the insulator coating film (overcoat film) is formed on the gate electrode provided by a plated wiring. It is understood that a flat surface is formed independent of roughness of a base as shown in Fig. 8.

As a result, the silicon nitride dielectric film (CVD dielectric film) 132 formed by CVD on the insulator coating film (overcoat film) 131 and having a thickness of 150 to 160 nm has a surface given a flatness of 0.70 nm in Ra and 7.54 nm in peak-to-valley value (Fig. 2). As a result, a thin film transistor (TFT) can be formed without causing the asperity deriving from the gate electrode to be produced on the semiconductor layer formed on the gate insulating film 13. Therefore, mobility of a carrier can significantly be improved.

As the insulator coating film (overcoat film) 131, SOG (spin-on glass) may be used. A SOG film is prepared by a siloxane component to be a film, an alcohol component as a solvent, and the like. The above-mentioned solution is applied onto the substrate by spin coating and the solvent and the like are evaporated by heat treatment to harden the film. As a result, a SOG insulating film is formed. The SOG is an inclusive term used to represent the above-mentioned solution and the film to be formed. Depending on a structure of siloxane, the SOG is classified into silica glass, an alkyl siloxane polymer, an alkyl silsesquioxane polymer (MSQ), a hydrogen silsesquioxane polymer (HSQ), and a hydrogen alkyl silsesquioxane polymer (HOSQ). In classification by a coating material, the silica glass is a first generation inorganic SOG, the alkyl siloxane polymer is a first generation organic SOG, the HSQ is a second generation inorganic SOG, and the MSQ and the HOST are a second generation organic SOG. To explain the coating film, baking is often carried out at a temperature not lower than 500 °C. In any event, a high temperature can not be used when the transparent resin layer is used. Therefore, a material having a baking temperature of not higher than 300 °C is used. Further, instead of the Si organic compounds and the Si inorganic compounds mentioned above, use may be made of a material which is obtained by dissolving at least one of another metal-organic compound and another metal-inorganic compound in an organic solvent (particularly, which has a baking temperature of not higher than 300 °C). As another metal, Ti, Ta, Al, Sn, Zr, and so on are exemplified.

Herein, if the gate insulating film 13 comprising the insulator coating film 131 and the CVD dielectric film 132 formed thereon is too thick, a driving capability of the transistor is degraded and a gate capacitance is increased to cause signal delay. Therefore, in a case of the silicon nitride dielectric film, it is preferable that the thickness is not greater than about 350 to 360 nm and not greater than 200 nm in EOT. The EOT is an equivalent silicon dioxide thickness obtained by dividing a dielectric constant of silicon dioxide by an average dielectric constant of a film and then multiplying a quotient by a film thickness. On the other hand, if the thickness of the gate insulating film is is too small, a leak current is increased. In a typical liquid crystal display device, the voltage of 15V at maximum is applied between a gate and a source of the TFT so that a withstand voltage is preferably not lower than 15V. Therefore, it is preferable that the thickness is not smaller than 95 nm in EOT.

In order to obtain a flat surface independent of the roughness of the base, the insulator coating film 131 is required to have a physical film thickness of at least 40 nm (if a surface roughness of the base is about 30 nm in peak-to-valley value). Although the film may have various dielectric constants, the dielectric constant is about 10 at maximum. Taking this into consideration, it is preferable that the thickness is not smaller than 15 nm in EOT. Furthermore, the maximum film thickness is preferably not greater than about 120 nm.

The CVD dielectric film 132 preferably has a thickness of not smaller than 80 nm in EOT, considering that the film is mainly responsible for a withstand voltage. The upper limit is preferably 200 nm - 15 nm = 185 nm. It is noted here that the CVD dielectric film 132 may be formed under the insulator coating film 131, not thereon, as in a third embodiment which will later be described, and may be omitted as in a second embodiment which will later be described.

Preferably, the insulator coating film 131 has a dielectric constant of not smaller than 2.6, while the CVD dielectric film 132 has a dielectric constant of not less than 4.0.

Next, a method of forming the thin film transistor of the first embodiment as mentioned above will be described using the drawings.

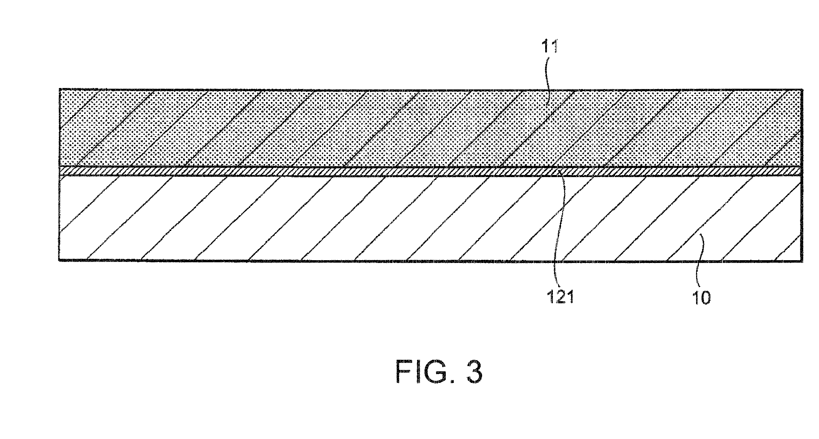

Figs. 3 through 7 are schematic diagrams showing, step by step, a method of manufacturing the thin film transistor according to the first embodiment. First, referring to Fig. 3, a glass substrate 10 is prepared as a substrate. As the glass substrate, a large-sized substrate adapted to form a large-sized screen of 30 inches or more may be used. The glass substrate is treated with a 0.5 vol% aqueous solution of hydrofluoric acid for 10 seconds and washed with pure water to remove surface contamination by liftoff. Next, the glass substrate 10 was treated with a silane coupling agent solution which was obtained by preparing an aqueous solution having pH controlled to 10 by adding sodium hydroxide to pure water and then dissolving aminopropylethoxysilane as a silane coupling agent in the aqueous solution at a concentration of 0.1 vol%. Specifically, the glass substrate was dipped into the silane coupling agent solution at a room temperature for 30 minutes to allow the silane coupling agent to be adsorbed onto a surface of the glass substrate. Thereafter, the glass substrate was treated on a hot plate at 110 °C for 60 minutes to chemically bond the silane coupling agent onto the surface of the glass substrate. Thus, the base adhesive layer (10 nm thick) 121 was formed. By forming the base adhesive layer 121 as mentioned above, an amino group is substantially arranged on the surface of the glass substrate 10. Therefore, a structure which allows easy coordination of a metal complex can be formed. The silane coupling agent is generally transparent. Therefore, even if the base adhesive layer is formed throughout the entire surface of the glass substrate 10, an effect of the present invention can be obtained. Furthermore, forming the base adhesive layer is preferable in view of obtaining adhesion between the glass substrate 10 and a transparent photosensitive resin which is used in a subsequent process.

After the base adhesive layer 121 was formed, a positive photoresist solution was applied to a surface of the base adhesive layer 121 by using a spinner. Then, prebaking was performed by heating on a hot plate at 100 °C for 120 seconds. Thus, the photosensitive transparent resin film 11 having a thickness of 2 µm was formed. As the positive photoresist mentioned above, use was made of a photoresist containing an alkali-soluble alicyclic olefin-based resin described in Patent Document 4 (JP-A-2002-296780). As an organic material for forming the transparent film, a transparent resin selected from a group including an acryl-based resin, a silicone-based resin, a fluorine-based resin, a polyimide-based resin, a polyolefin-based resin, an alicyclic olefin resin, and an epoxy-based resin is usable. However, from an aspect of facilitating subsequent processes, a photosensitive transparent resin film containing the alkali-soluble alicyclic olefin-based resin and a radiation-sensitive component is advantageous as the transparent film. Especially, it is preferable to use a photosensitive transparent resin composition as described in detail in Patent Document 4 or Patent Document 5 (JP-A-2001-188343).

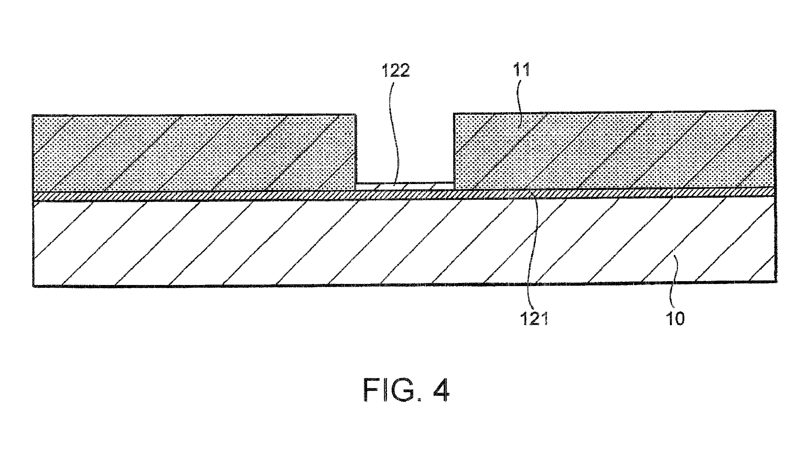

Referring to Fig. 4, after the photosensitive transparent resin film 11 was formed, a mixed light of g, h, and i rays was selectively irradiated onto the photosensitive transparent resin film 11 through a mask pattern using a mask aligner. Then, after development for 90 seconds with a 0.3 wt% tetramethylammonium hydroxide aqueous solution, rinsing was carried out with pure water for 60 seconds. In this manner, a trench having a predetermined pattern was formed on the glass substrate 10. Thereafter, a heat treatment was carried out in a nitrogen atmosphere at 230 °C for 60 minutes to thereby harden the photosensitive transparent resin film 11. Next, the substrate was dipped into a palladium chloride-hydrochloric acid aqueous solution (0.005 vol% palladium chloride, 0.01 vol% hydrochloric acid) at a room temperature for 3 minutes, treated with a reducing agent (Reducer MAB-2 manufactured by C. Uyemura & Co., Ltd.), and washed with water. As a result, the palladium catalyst (catalyst layer: 10 to 50 nm thick) 122 was selectively provided to the trench formed as mentioned above.

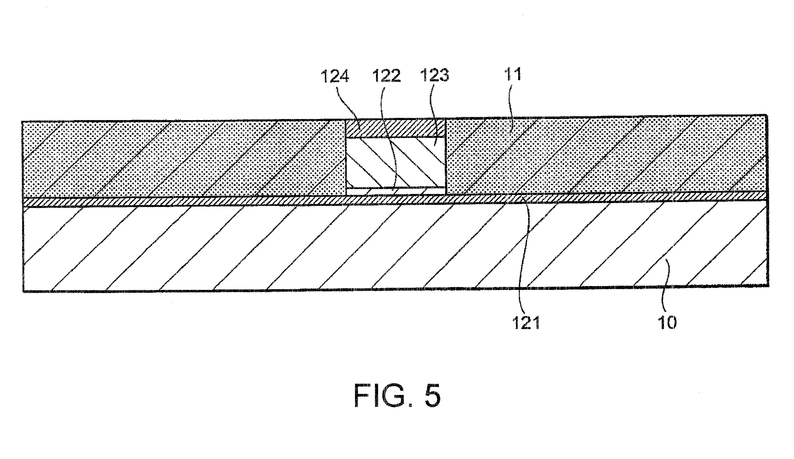

Referring to Fig. 5, the substrate provided with the palladium catalyst 122 was dipped into an electroless copper plating solution (PGT manufactured by C. Uyemura & Co., Ltd.) to selectively form the copper layer 123 (conductive metal layer: 1.9 µm thick) in the trench mentioned above. Preferably, formation of the copper layer 123 is finished at a position lower than a height of the surface of the photosensitive transparent resin film 11 by a film thickness of the diffusion suppressing film (conductive metal diffusion suppressing layer) 124 subsequently formed. Next, the substrate was dipped into an electroless nickel plating solution to form the diffusion suppressing film 124 (0.1 µm thick) of nickel on the copper layer 123. Herein, it is preferable that the conductive metal layer 123 contains at least one of Cu and Ag and that the diffusion suppressing film (conductive metal diffusion suppressing layer) 124 contains a metal selected from Ni, W, Ta, Nb, and Ti. The conductive metal layer may be formed by printing, ink-jet, or sputtering, instead of plating. For example, in a case of sputtering, Al is suitable as the metal instead of Cu and Ag. If Al is used, the diffusion suppressing film (conductive metal diffusion suppressing layer) may be omitted.

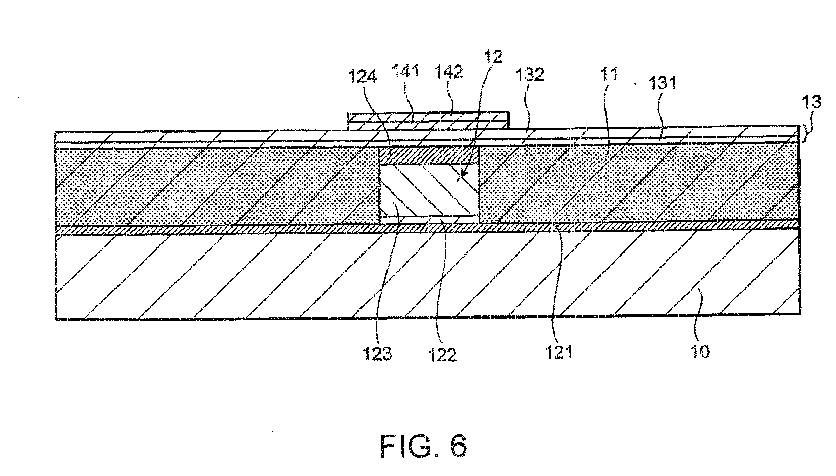

Referring to Fig. 6, next, the insulator coating film 131 was formed so as to extend over the surface of the gate electrode 12 and the surface of the photosensitive transparent resin film 11. The insulator coating film 131 is obtained by applying a liquid which is prepared by dissolving organosiloxane as a Si organic compound in an organic solvent (propylene glycol monomethyl ether), keeping at 120 °C in an atmosphere for 90 seconds to dry, and then baking in an atmosphere (may also be in a nitrogen gas) at 180 °C for 1 hour. Next, by a microwave excited RLSA plasma processing device, the Si₃N₄ film (silicon nitride dielectric film) 132 was grown by CVD to form the gate insulating film 13. Next, an amorphous silicon film 141 and an n⁺-type amorphous silicon film 142 were successively deposited by known PECVD (Plasma Enhanced Chemical Vapor Deposition). Then, the amorphous silicon films were partially removed except in an area on the gate electrode 12 and its surrounding area by photolithography or known RIE (Reactive Ion Etching).

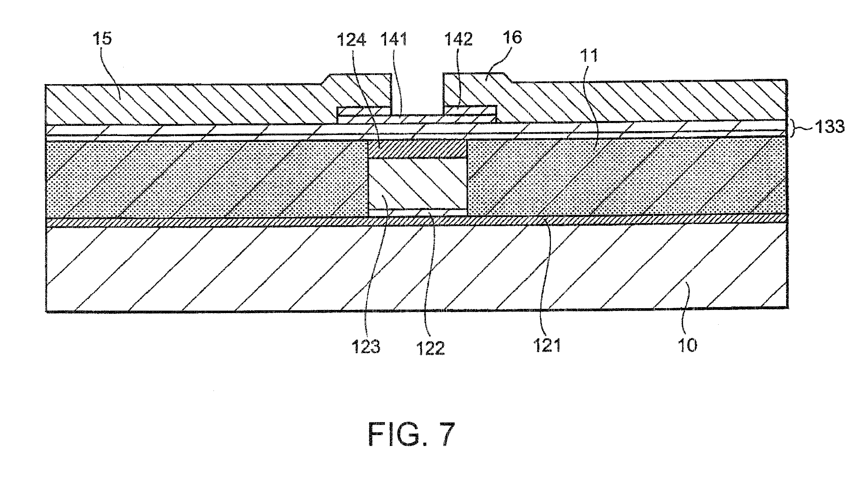

Referring to Fig. 7, for the purpose of forming a source electrode and a drain electrode, film formation was subsequently carried out in order of Ti, Al, and Ti by known sputtering or the like and patterning was carried out by photolithography. As a result, the source electrode 15 and the drain electrode 16 were formed. Next, using, as a mask, the source electrode 15 and the drain electrode 16 thus formed, the n⁺-type amorphous silicon film 142 was etched by a known technique to thereby separate a source region and a drain region. Next, by known PECVD, a silicon nitride film (not shown) was formed as a protective film. As a result, the thin film transistor of the first embodiment was completed.

### [Second Embodiment]

A second embodiment of the present invention will be described using the drawings.

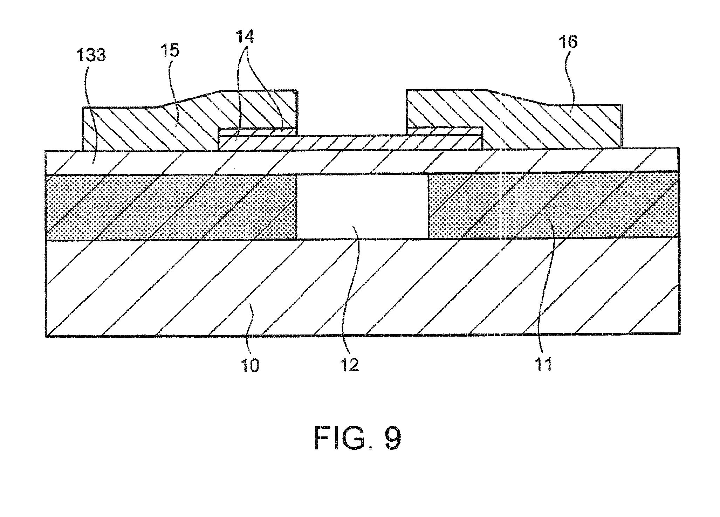

Fig. 9 is a sectional view showing a structure of a thin film transistor (TFT) according to the second embodiment of the present invention, which is applicable to a liquid crystal display device. The thin film transistor comprises a transparent resin film 11 formed on a glass substrate (insulating substrate) 10 and formed of a transparent photosensitive resin, a gate electrode 12 formed in the transparent resin film 11 so as to reach the glass substrate 10 and formed to a height approximately same as that of the transparent resin film 11, a gate insulating film 133 formed over the transparent resin film 11 and the gate electrode 12 and comprising an insulator coating film, a semiconductor layer 14 formed on the gate electrode 12 via the gate insulating film 133, and a source electrode 15 and a drain electrode 16 each of which is connected to the semiconductor layer 14.

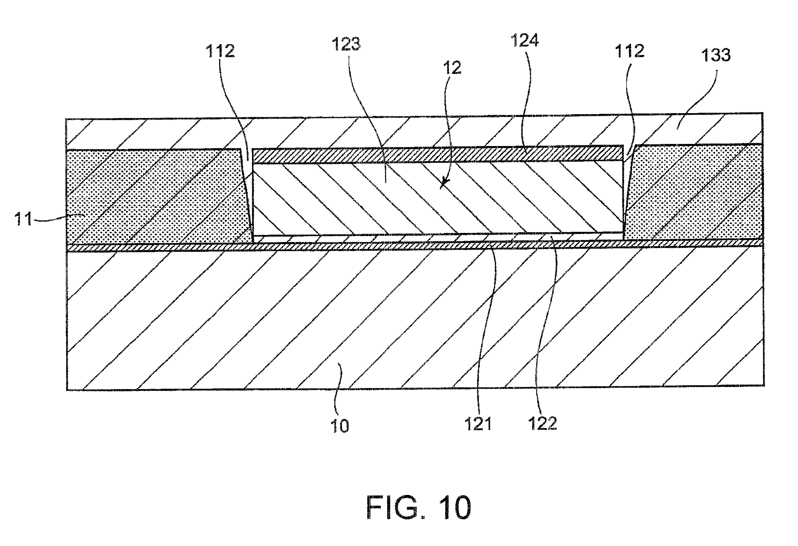

Fig. 10 is an enlarged sectional view showing a structure of a gate electrode portion of the thin film transistor according to the second embodiment. The gate electrode 12 illustrated in the figure comprises, from the side of the glass substrate 10 toward the side of the semiconductor layer (namely, in order from the bottom of the figure), a base adhesive layer 121, a catalyst layer 122, a conductive metal layer 123, and a conductive metal diffusion suppressing layer 124. The gate electrode 12 is embedded in a trench formed in the flat transparent resin film 11. As shown in the figure, the gate electrode 12 is embedded in the trench of the transparent resin film 11 so that an upper surface of the gate electrode and that of the transparent resin film 11 are approximately flush with each other. Therefore, flatness of an upper structure of the gate electrode 12 is ensured. However, there is a problem in flatness at a microscopic level. Specifically, a surface of the conductive metal layer 123 (Cu layer) formed by conventional electroless plating has a flatness up to 17.74 nm in Ra and 193.92 nm in peak-to-valley value. A surface of the conductive metal diffusion suppressing layer to (electroless plated Ni layer) formed thereon also has a flatness of 8.58 nm in Ra and 68.7 nm in peak-to-valley value.

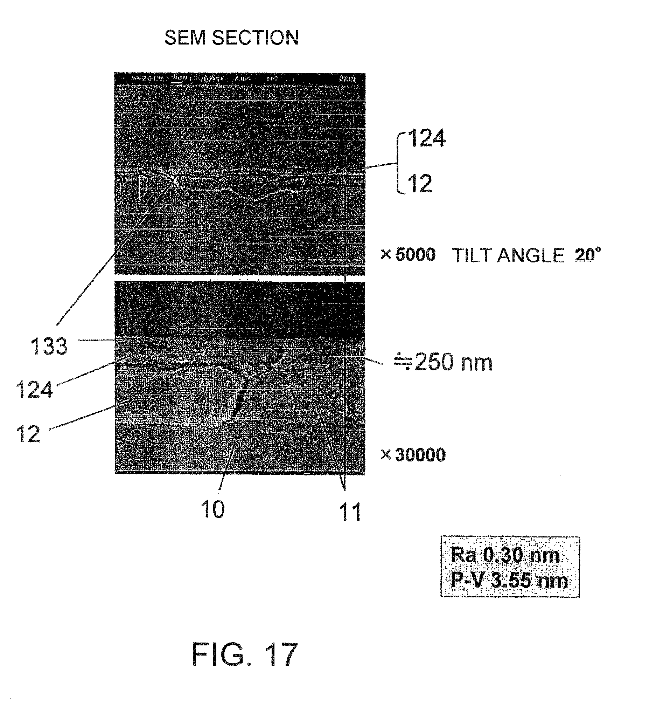

In the present invention, the insulator coating film (gate insulating film) 133 having a thickness of 250 nm is formed on the conductive metal diffusion suppressing layer 124. The insulator coating film 133 filled a gap 112 between the gate electrode 12 and the transparent resin film 11 and provided the gate insulating film having a flat surface which did not reflect asperity of the surface of the gate electrode 12 and which had a flatness of 0.30 nm in Ra and 3.55 nm in peak-to-valley value. Fig. 17 is an electron micrograph showing a state, as observed in section, of a structure in which the gate insulating film comprising the insulator coating film is formed on the gate electrode. It is understood that a flat surface is formed independent of roughness of a base as shown in Fig. 17.

As a result, a thin film transistor (TFT) can be formed without causing the asperity deriving from the gate electrode 12 to be produced on the semiconductor layer formed on the gate insulating film. Therefore, mobility of a carrier can significantly be improved. Furthermore, in a film forming process of the gate insulating film, a CVD process for forming a CVD dielectric film is omitted and film formation is performed by a simple coating process. Thus, simplification of the process was achieved.

Next, a method of forming the thin film transistor of the second embodiment as mentioned above will be described using the drawings.

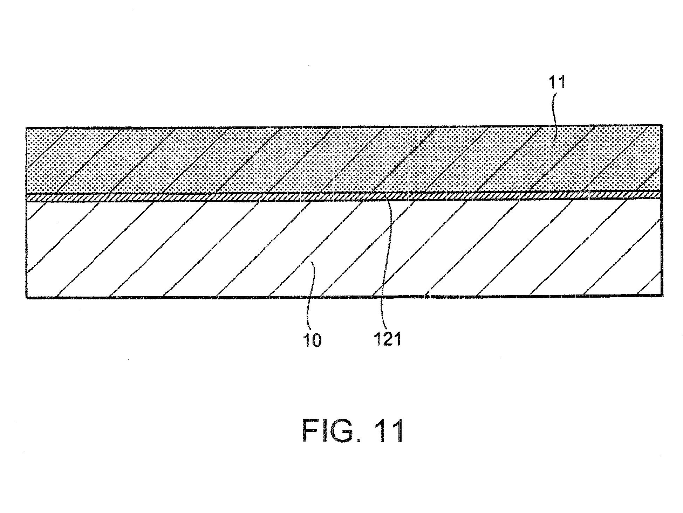

Figs. 11 through 15 are schematic diagrams showing, step by step, a method of manufacturing the thin film transistor according to the second embodiment. First, referring to Fig. 11, the glass substrate 10 is prepared as a substrate. As the glass substrate, a large-sized substrate adapted to form a large-sized screen of 30 inches or more may be used. The glass substrate is treated with a 0.5 vol% aqueous solution of hydrofluoric acid for 10 seconds and washed with pure water to remove surface contamination by liftoff. Next, the glass substrate 10 was treated with a silane coupling agent solution which was obtained by preparing an aqueous solution having pH controlled to 10 by adding sodium hydroxide to pure water and then dissolving aminopropylethoxysilane as a silane coupling agent in the aqueous solution at a concentration of 0.1 vol%. Specifically, the glass substrate was dipped into the silane coupling agent solution at a room temperature for 30 minutes to allow the silane coupling agent to be adsorbed onto the glass substrate 10. Thereafter, the glass substrate 10 was treated on a hot plate at 110 °C for 60 minutes to chemically bond the silane coupling agent onto the surface of the glass substrate. Thus, the base adhesive layer (10 nm thick) 121 was formed. By forming the base adhesive layer 121 as mentioned above, an amino group is substantially arranged on the surface of the substrate. Therefore, a structure which allows easy coordination of a metal complex can be formed. The silane coupling agent is generally transparent. Therefore, even if the base adhesive layer is formed throughout the entire surface of the glass substrate 10, an effect of the present invention can be obtained. Furthermore, forming the base adhesive layer is preferable in view of obtaining adhesion between the glass substrate 10 and a transparent photosensitive resin which is used in a subsequent process.

After the base adhesive layer 121 was formed, a positive photoresist solution was applied to a surface of the base adhesive layer 121 by using a spinner. Then, prebaking was performed by heating on a hot plate at 100 °C for 120 seconds. Thus, the photosensitive transparent resin film 11 having a thickness of 2 µm was formed. As the positive photoresist mentioned above, use was made of a photoresist containing an alkali-soluble alicyclic olefin-based resin described in the publication of Patent Document 4. As an organic material for forming the transparent film, a transparent resin selected from a group including an acryl-based resin, a silicone-based resin, a fluorine-based resin, a polyimide-based resin, a polyolefin-based resin, an alicyclic olefin resin, and an epoxy-based resin is usable. However, from an aspect of facilitating subsequent processes, a photosensitive transparent resin film is advantageous as the transparent film. Especially, it is preferable to use a photosensitive transparent resin composition as described in detail in Patent Document 4 or Patent Document 5.

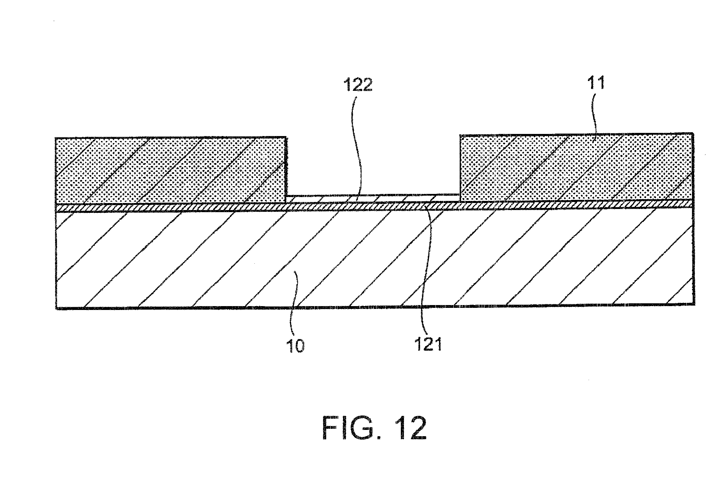

Referring to Fig. 12, after the photosensitive transparent resin film 11 was formed, a mixed light of g, h, and i rays was selectively irradiated onto the photosensitive transparent resin film 11 through a mask pattern using a mask aligner. Then, after development for 90 seconds with a 0.3 wt% tetramethylammonium hydroxide aqueous solution, rinsing was carried out with pure water for 60 seconds. In this manner, a trench having a predetermined pattern was formed on the glass substrate 10. Thereafter, a heat treatment was carried out in a nitrogen atmosphere at 230 °C for 60 minutes to thereby harden the photosensitive transparent resin film 11. Next, the substrate was dipped into a palladium chloride-hydrochloric acid aqueous solution (0.005 vol% palladium chloride, 0.01 vol% hydrochloric acid) at a room temperature for 3 minutes, treated with a reducing agent (Reducer MAB-2 manufactured by C. Uyemura & Co., Ltd.), and washed with water. As a result, the palladium catalyst (catalyst layer: 10 to 50 nm thick) 122 was selectively provided to the trench formed as mentioned above.

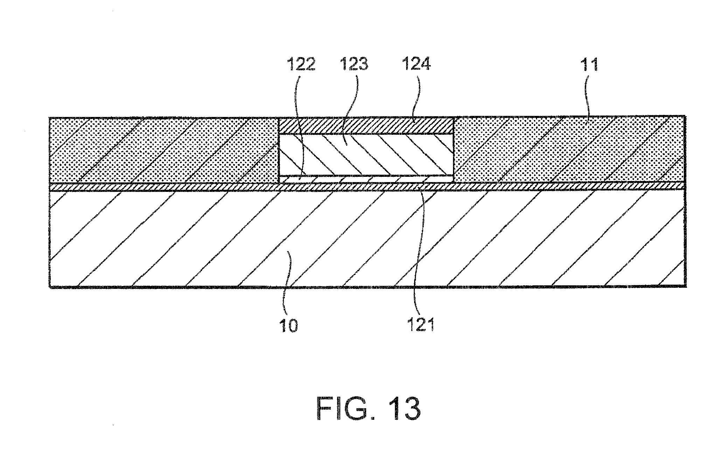

Referring to Fig. 13, the glass substrate 10 provided with the palladium catalyst 122 was dipped into an electroless copper plating solution (PGT manufactured by C. Uyemura & Co., Ltd.) to selectively form the copper layer 123 (1.9 µm tick) as the conductive metal layer in the trench mentioned above. Preferably, formation of the copper layer 123 is finished at a position lower than a height of the surface of the photosensitive transparent resin film 11 by a film thickness of the diffusion suppressing film (conductive metal diffusion suppressing layer) 124 subsequently formed. Next, the substrate was dipped into an electroless nickel plating solution to form the diffusion suppressing film 124 (0.1 µm thick) of nickel on the copper layer 123.

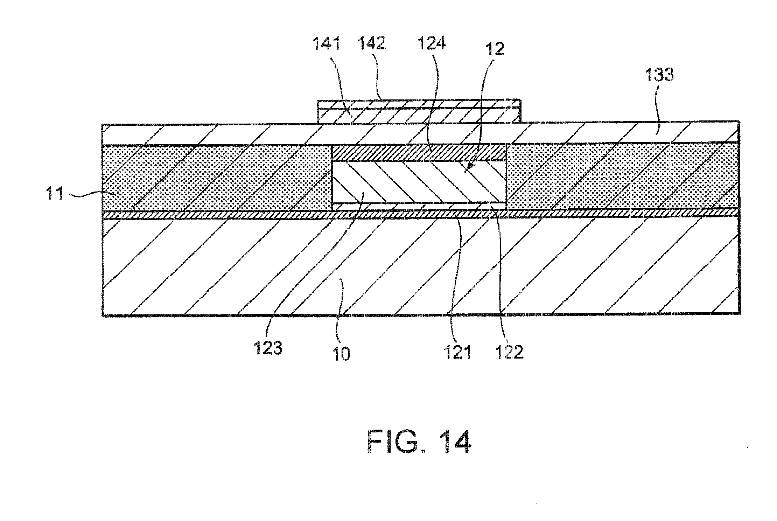

Referring to Fig. 14, next, an insulator film was applied so as to extend over the surface of the gate electrode 12 and the surface of the photosensitive transparent resin film 11 to form the gate insulating film 133. The gate insulating film 133 was obtained by applying a liquid which was prepared by dissolving organosiloxane as a Si organic compound in an organic solvent (propylene glycol monomethyl ether), keeping at 120 °C in an atmosphere for 90 seconds to dry, and then baking in an atmosphere (may also be in a nitrogen gas) at 180 °C for 1 hour. Next, an amorphous silicon film 141 and an n⁺-type amorphous silicon film 142 were successively deposited by known PECVD. Then, the amorphous silicon films were partially removed except in an area on the gate electrode 12 and its surrounding area by photolithography or known RIE.

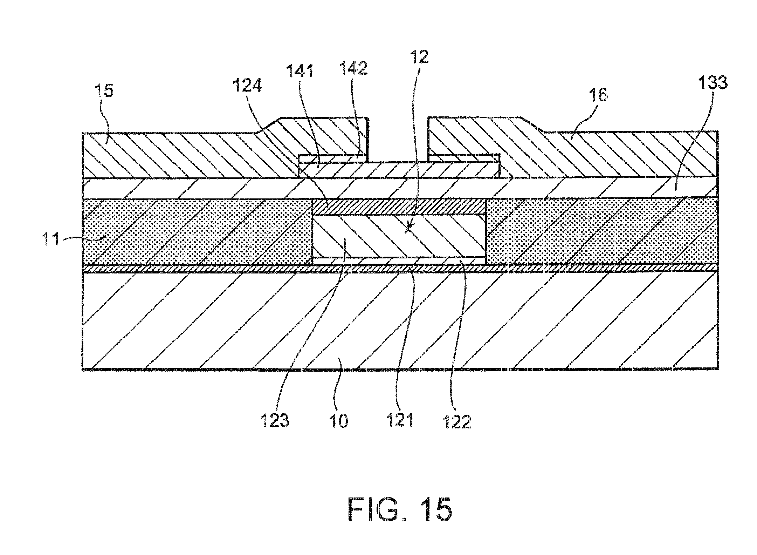

Referring to Fig. 15, for the purpose of forming a source electrode and a drain electrode, film formation was subsequently carried out in order of Ti, Al, and Ti by known sputtering or the like and patterning was carried out by photolithography. As a result, the source electrode 15 and the drain electrode 16 were formed. Next, using, as a mask, the source electrode 15 and the drain electrode 16 thus formed, the n⁺-type amorphous silicon film 142 was etched by a known technique to thereby separate a source region and a drain region. Next, by known PECVD, a silicon nitride film (not shown) was formed as a protective film. As a result, the thin film transistor of the second embodiment was completed.

### [Third Embodiment]

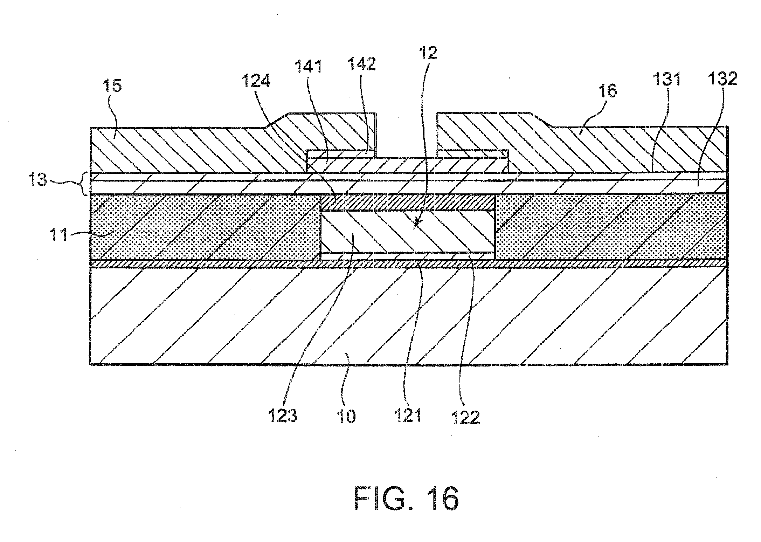

A method of forming a thin film transistor according to a third embodiment and applicable to a liquid crystal display device will be described using Fig. 16.

In the method of manufacturing the thin film transistor described in the second embodiment, the diffusion suppressing film 124 (0.1 µm thick) of nickel was formed on the copper layer 123 to form the gate electrode 12. Thereafter, over an entire region from the surface of the gate electrode 12 to the surface of the transparent resin film 11, the Si₃N₄ film (silicon nitride dielectric film) 132 was grown by CVD using a microwave excited RLSA plasma processing device to form an insulating film. Next, the insulator coating film 131 was applied and formed over the Si₃N₄ film 132 throughout its entirety. As a result, the gate insulating film 13 was formed. The insulator coating film 131 was obtained by applying a liquid which was prepared by dissolving organosiloxane as a Si organic compound in an organic solvent (propylene glycol monomethyl ether), keeping at 120 °C in an atmosphere for 90 seconds to dry, and then baking in an atmosphere (may also be in a nitrogen gas) at 180 °C for 1 hour. By forming the insulator coating film 31, it was possible to reduce a surface roughness of the surface of the insulating film (Si₃N₄ film 132), which resulted from CVD growth on the gate electrode 12 formed thereunder and having a large surface roughness. Accordingly, it was possible to reduce a roughness at an interface between the gate insulating film as a channel layer and a semiconductor layer. Fig. 16 is a sectional view of the thin film transistor in this case.

In the foregoing embodiments, description has exclusively been made about those cases where the present invention is applied to the liquid crystal display device. However, the present invention is also applicable to an organic EL display device, various substrates constituting a fiat display panel, and other wiring substrates.

Furthermore, as a wire-forming material, a material other than copper and silver may also be used. For example, a conductive film of metal oxide, such as indium-tin oxide (ITO), may be formed.

### Industrial Applicability:

The present invention is applicable to a display device, such as a liquid crystal display device, an organic EL device, and an inorganic EL device, and makes it possible to increase the size of these display devices. Furthermore, the present invention is applicable also to a wiring other than the display devices.

## Claims

1. A semiconductor device comprising a substrate; an insulator layer formed on the substrate and having a trench; a conductor layer formed in the trench so that an upper surface of the conductor layer is approximately flush with an upper surface of the insulator layer; an insulating film formed on the conductor layer; and a semiconductor layer formed on the insulating film above at least a part of the conductor layer; wherein:
the insulating film includes an insulator coating film.

2. The semiconductor device as claimed in claim 1, wherein the insulating film comprises only the insulator coating film.

3. The semiconductor device as claimed in claim 1, wherein the insulating film further includes an additional insulator film.

4. The semiconductor device as claimed in claim 3, wherein the additional insulator film is an insulator CVD film.

5. The semiconductor device as claimed in claim 3, wherein the additional insulator film is formed between the insulator coating film and the semiconductor layer.

6. The semiconductor device as claimed in claim 3, wherein the additional insulator film is formed between the insulator coating film and the conductor layer.

7. The semiconductor device as claimed in claim 1, wherein a part of the conductor layer is a gate electrode, the insulating film on the gate electrode being a gate insulating film, the semiconductor layer being formed on the gate insulating film.

8. The semiconductor device as claimed in claim 7, wherein at least one of a source electrode and a drain electrode is electrically connected to the semiconductor layer.

9. A semiconductor device comprising an insulator layer formed on a substrate and provided with a trench, a gate electrode formed as a conductor layer in the trench so that an upper surface of the gate electrode is approximately flush with an upper surface of the insulator layer, and a semiconductor layer arranged on the gate electrode via a gate insulating film and electrically connected to at least one of a source electrode and a drain electrode, wherein:
the gate insulating film comprises an insulator coating film formed on the gate electrode and an insulator CVD film formed on the insulator coating film.

10. The semiconductor device as claimed in claim 1 or 9, wherein a surface of the insulator coating film has a flatness of not greater than 1 nm in Ra and not greater than 20 nm in peak-to-valley value.

11. The semiconductor device as claimed in claim 7 or 9, wherein a surface of the gate electrode has a flatness of not smaller than 3 nm in Ra and not smaller than 30 nm in peak-to-valley value.

12. The semiconductor device as claimed in claim 1 or 9, wherein the substrate is a substantially transparent insulator substrate, the insulator layer being a substantially transparent resin layer.

13. The semiconductor device as claimed in claim 12, wherein the transparent resin layer is formed of a photosensitive resin composition containing an alkali-soluble alicyclic olefin-based resin and a radiation-sensitive component.

14. The semiconductor device as claimed in claim 12, wherein the transparent resin layer contains one or more kinds of resins selected from a group including an acryl-based resin, a silicone-based resin, a fluorine-based resin, a polyimide-based resin, a polyolefin-based resin, an alicyclic olefin-based resin, and an epoxy-based resin.

15. The semiconductor device as claimed in claim 7 or 9, wherein the gate electrode comprises at least a base adhesive layer, a conductive metal layer, and a conductive metal diffusion suppressing layer.

16. The semiconductor device as claimed in claim 1 or 9, wherein the insulator coating film fills a gap between the conductor layer and the insulator layer and extends over the surface of the insulator layer.

17. The semiconductor device as claimed in claim 7 or 9, wherein the insulator coating film is substantially transparent, fills a gap between the gate electrode and the insulator layer, and extends over the surface of the insulator layer.

18. The semiconductor device as claimed in claim 4 or 9, wherein the insulator CVD film is substantially transparent and extends over the insulator coating film extending over the surface of the insulator layer.

19. The semiconductor device as claimed in claim 1 or 9, wherein the insulator coating film is a film obtained by drying and baking a liquid coating film containing at least one of a metal organic compound and a metal inorganic compound and a solvent.

20. The semiconductor device as claimed in claim 1 or 9, wherein the insulator layer is a substantially transparent resin layer, the insulator coating film being a film obtained by drying and baking, at a temperature not higher than 300 °C, a liquid coating film containing at least one of a metal organic compound and a metal inorganic compound and a solvent.

21. The semiconductor device as claimed in claim 1 or 9, wherein the insulator coating film has a dielectric constant of not smaller than 2.6.

22. The semiconductor device as claimed in claim 4 or 9, wherein the insulator CVD film has a dielectric constant of not smaller than 4.

23. The semiconductor device as claimed in claim 7 or 9, wherein the gate insulating film has a thickness between 95 nm and 200 nm in EOT (equivalent silicon dioxide thickness).

24. The semiconductor device as claimed in claim 4 or 9, wherein the insulator CVD film has a thickness between 80 nm and 185 nm in EOT (equivalent silicon dioxide thickness).

25. The semiconductor device as claimed in claim 1 or 9, wherein the insulator coating film has a thickness between 15 nm and 120 nm in EOT (equivalent silicon dioxide thickness).

26. The semiconductor device as claimed in claim 15, wherein the conductive metal layer contains at least one of Cu and Ag, the conductive metal diffusion suppressing layer containing a metal selected from Ni, W, Ta, Nb, and Ti.

27. A display device manufactured by using the semiconductor device claimed in claim 1 or 9.

28. The display device as claimed in claim 27, wherein the display device is a liquid crystal display device or an organic EL display device.

29. A method of manufacturing a semiconductor device, the method including:
a step of providing an insulator layer having a trench on a substrate;
a step of forming a conductor layer in the trench so that an upper surface of the conductor layer is approximately flush with an upper surface of the insulator layer;
a step of forming an insulator coating film on the conductor layer; and
a step of forming a semiconductor layer on at least a part of the insulator coating film.

30. The method of manufacturing a semiconductor device as claimed in claim 29, the method including, before or after the step of forming the insulator coating film, a step of forming an additional insulator film.

31. The method of manufacturing a semiconductor device as claimed in claim 30, wherein the additional insulator film is formed by CVD.

32. The method of manufacturing a semiconductor device as claimed in claim 29, wherein a part of the conductor layer is a gate electrode, the insulator coating film on the gate electrode being at least a part of a gate insulating film, the semiconductor layer being formed on the gate insulating film.

33. The method of manufacturing a semiconductor device as claimed in claim 32, the method further including a step of forming at least one of a source electrode and a drain electrode on the semiconductor layer.

34. A method of manufacturing a semiconductor device, the method including:
a step of providing an insulator layer having a trench on a substrate;
a step of forming a gate electrode in the trench so that an upper surface of the gate electrode is approximately flush with an upper surface of the insulator layer;
a step of forming an insulator coating film on the gate electrode;
a step of forming a dielectric film by CVD on the insulator coating film;
a step of forming a semiconductor layer on the dielectric film; and
a step of electrically connecting at least one of a source electrode and a drain electrode to the semiconductor layer.

35. The method of manufacturing a semiconductor device as claimed in claim 32 or 34, wherein the step of forming the insulator coating film includes:
a step of applying, onto the gate electrode, a liquid material containing at least one of a metal organic compound and a metal inorganic compound and a solvent;
a step of drying an applied film; and
a step of baking a dried film.

36. The method of manufacturing a semiconductor device as claimed in claim 32 or 34, wherein the step of forming the gate electrode includes:
a step of forming a conductive metal layer by plating, printing, ink-jet, or sputtering.

37. The method of manufacturing a semiconductor device as claimed in claim 35, wherein the step of forming the insulator coating film includes a step of applying the liquid material so as to fill a gap between the gate electrode and the insulator layer and to extend over a surface of the insulator layer.

38. The method of manufacturing a semiconductor device as claimed in claim 29 or 34, wherein the step of providing the insulator layer having the trench on the substrate includes:
a step of forming a resin film on the substrate; and
a step of forming the trench for receiving the gate electrode by patterning the resin film.

39. The method of manufacturing a semiconductor device as claimed in claim 35, wherein the step of baking the dried film is carried out in an inactive gas atmosphere or in an air atmosphere.

40. A method of manufacturing a liquid crystal display device or an organic EL display device, the method including a step of forming a semiconductor device by using the method claimed in claim 29 or 34.
